# EUROPEAN PATENT APPLICATION

(11) **EP 2 763 170 A1**
(43) Date of publication of application: **06.08.2014**
(21) Application number: 13185038.0
(22) Date of filing: 18.09.2013
(51) Int. Cl.: H01L 25/04, H01L 51/52, F21Y 105/00, F21S 2/00, H01L 27/32

(54) **Lighting device**

(30) Priority: 01.02.2013 JP 2013018975
(71) Applicant: Toshiba Lighting & Technology Corporation, Yokosuka-shi, Kanagawa 237-8510 (JP); Kabushiki Kaisha Toshiba, Minato-ku, Tokyo 105-8001 (JP)
(72) Inventor: Okawa, Hideki, Kanagawa, 237-8510 (JP); Hayashi, Junya, Kanagawa, 237-8510 (JP); Kamata, Hiroshi, Kanagawa, 237-8510 (JP); Takahashi, Yoshimasa, Kanagawa, 237-8510 (JP)
(74) Representative: Bokinge, Ole

(57) **Abstract**

According to one embodiment, there is provided a lighting device (100) including a plurality of panels (120); a frame (110); and a connection body (130). The panel (120) emits light by organic electro-luminescence. The frame (110) is formed of a material which is an insulating material and transmits the light. The frame (110) seals the plurality of panels (120). The connection body (130) has conductivity. The panel (120) has a substrate (121), a first electrode (122), a second electrode (125), a first conductive body (122a), and a second conductive body (125a). The substrate (121) is formed of a light transmitting material. The first electrode (122) supplies a voltage to the panel (120) provided on the substrate (121). The second electrode (125) supplies the voltage to the panel (120) provided on the substrate (121). The first conductive body (122a) has conductivity, is connected to the first electrode (122), and is provided in a first side surface (121d) of the substrate (121). The second conductive body (125a) has conductivity, is connected to the second electrode (125), and is provided in a second side surface (121e) of the substrate (121). The plurality of panels (120) are electrically connected to each other via the first conductive body (122a), the second conductive body (125a), and the connection body (130).

## Description

### FIELD

Embodiments described herein relate generally to a lighting device.

### BACKGROUND

Generally, it is known that Organic Light-Emitting Diode (OLED) panel (a transparent OLED panel) which becomes transparent when off-lighting is obtained due to use of Indium Tin Oxide (ITO) which dopes tin used for a transparent electrode in a minus electrode. It is possible to form an OLED lighting device which becomes transparent when off-lighting by assembling a plurality of transparent OLED panels.

When assembling the plurality of transparent OLED panels, it is necessary to secure mechanical strength of the OLED lighting device. For example, it can be exemplified that a frame is formed of a transparent material (for example, plastic, glass or the like) and the transparent OLED panels are assembled in the frame. In this case, it is necessary to supply a voltage to the plurality of transparent OLED panels while ensuring the transparency of all lighting devices.

### BRIEF DESCRIPTION OF THE DRAWINGS

FIG. 1 is a schematic plan view illustrating a lighting device according to an exemplary embodiment.
FIGS. 2A to 2C are schematic cross-sectional views illustrating a panel and the lighting device of the embodiment.
FIGS. 3A and 3B are schematic cross-sectional views illustrating the lighting device of the embodiment.
FIGS. 4A and 4B are schematic perspective views illustrating the panel of the embodiment.
FIGS. 5A to 5C are schematic views illustrating the panel of the embodiment.
FIGS. 6A and 6B are schematic perspective views illustrating another panel of the embodiment.
FIG. 7 is a schematic plan view illustrating an example of an electrical connection of the embodiment.
FIGS. 8A and 8B are schematic views illustrating another example of the electrical connection of the embodiment.

### DETAILED DESCRIPTION

According to a first exemplary embodiment, there is provided a lighting device including: a plurality of panels which emit light by organic electro-luminescence; a frame formed of a light transmitting material which is an insulating material, and sealing the plurality of panels; and a connection body having conductivity, in which the panel includes a substrate formed of a light transmitting material, a first electrode which is provided on the substrate and supplies a voltage to the panel, a second electrode which is provided on the substrate and supplies a voltage to the panel, a first conductive body which has conductivity, is connected to the first electrode, and is provided on a first side surface of the substrate, and a second conductive body which has conductivity, is connected to the second electrode, and is provided on a second side surface of the substrate, and in which the plurality of panels are electrically connected to each other via the first conductive body, the second conductive body and the connection body.

According to a second exemplary embodiment, in the lighting device according to the first exemplary embodiment, the frame includes a concave section in which the panel is disposed, and the connection body is provided on a side wall of the concave section.

According to a third exemplary embodiment, in the lighting device according to the second exemplary embodiment, the frame includes a first frame body in which the concave section is formed and a second frame body which is provided on the first frame body and covers the panel, and the connection body is further provided on a bonding surface of the first frame body and the second frame body.

According to a fourth exemplary embodiment, in the lighting device according to the first exemplary embodiment, the first conductive body includes at least one of metal paste, carbon paste, conductive tape, and a solder material.

According to a fifth exemplary embodiment, in the lighting device according to the first exemplary embodiment, the second conductive body includes at least one of metal paste, carbon paste, conductive tape, and a solder material.

According to a sixth exemplary embodiment, in the lighting device according to the first exemplary embodiment, the connection body includes at least one of metal paste, carbon paste, conductive tape and a solder material.

According to a seventh exemplary embodiment, the lighting device according to the first exemplary embodiment, further includes: a third conductive body which is provided between the first conductive body and the connection body and includes at least one of metal paste, carbon paste, conductive tape, and a solder material; and a fourth conductive body which is provided between the second conductive body and the connection body and includes at least one of metal paste, carbon paste, conductive tape, and a solder material, in which the first conductive body is electrically connected to the connection body via the third conductive body, and in which the second conductive body is electrically connected to the connection body via the fourth conductive body.

According to an eighth exemplary embodiment, in the lighting device according to the first exemplary embodiment, the first electrode includes an auxiliary wiring which passes through an emitting region of the panel, extends to a first end portion of the substrate and is electrically connected to the first conductive body, when viewing the lighting device from the direction perpendicular to a first main surface of the substrate, in which a plurality of auxiliary wirings and a plurality of second electrodes are provided, the plurality of auxiliary wirings are provided at a position spaced from each other in a predetermined pitch on the entire of the first main surface, and the plurality of second electrodes are provided at a position spaced from each other in a predetermined pitch on the entire of the first main surface.

According to a ninth exemplary embodiment, in the lighting device according to the eighth exemplary embodiment, the plurality of auxiliary wirings are electrically connected to each other via the first conductive body, and the plurality of second electrodes are electrically connected to each other via the second conductive body.

According to a tenth exemplary embodiment, in the lighting device according to the eighth exemplary embodiment, the auxiliary wiring includes a structure in which a plurality of layers are laminated.

According to an eleventh exemplary embodiment, in the lighting device according to the tenth exemplary embodiment, the auxiliary wiring includes a first layer, a second layer, and a third layer, in which the third layer is provided on the first layer, and in which the second layer is provided between the first layer and the third layer.

According to a twelfth exemplary embodiment, in the lighting device according to the eleventh exemplary embodiment, the first layer and the third layer include molybdenum, and the second layer includes aluminum.

According to a thirteenth exemplary embodiment, in the lighting device according to the eleventh exemplary embodiment, the auxiliary wiring further includes an insulation layer provided on a surface of a laminated body in which the first layer, the second layer and the third layer are laminated, and the insulation layer insulates an electrical connection between the first layer, the second layer, the third layer and the second electrode.

According to a fourteenth exemplary embodiment, in the lighting device according to the eighth exemplary embodiment, the first conductive body is formed on the entire surface of the first side surface and is electrically connected to the plurality of auxiliary wirings.

According to a fifteenth exemplary embodiment, in the lighting device according to the eighth exemplary embodiment, the second conductive body is formed on the entire surface of the second side surface and is electrically connected to the plurality of second electrodes.

According to a sixteenth exemplary embodiment, in the lighting device according to the fourteenth exemplary embodiment, the first conductive body is further provided on a second main surface of the substrate, a third side surface of the substrate and a fourth side surface of the substrate, and is electrically connected to the plurality of auxiliary wirings.

According to a seventeenth exemplary embodiment, in the lighting device according to the fifteenth exemplary embodiment, the second conductive body is further provided on a second main surface of the substrate, a third side surface of the substrate and a fourth side surface of the substrate and is electrically connected to the plurality of second electrodes.

According to an eighteenth exemplary embodiment, in the lighting device according to the sixteenth exemplary embodiment, the first conductive body is provided toward the second conductive body in the third side surface while maintaining an insulation distance with respect to the second conductive body.

According to a nineteenth exemplary embodiment, in the lighting device according to the seventeenth exemplary embodiment, the second conductive body is provided toward the first conductive body in the fourth side surface while maintaining an insulation distance with respect to the first conductive body.

According to a twentieth exemplary embodiment, in the lighting device according to the first exemplary embodiment, the plurality of panels are connected to each other in series.

Hereinafter, an exemplary embodiment will be described with reference to drawings. In addition, the same reference numerals are given to the same configuration elements in each drawing and detailed description thereof will be omitted appropriately.

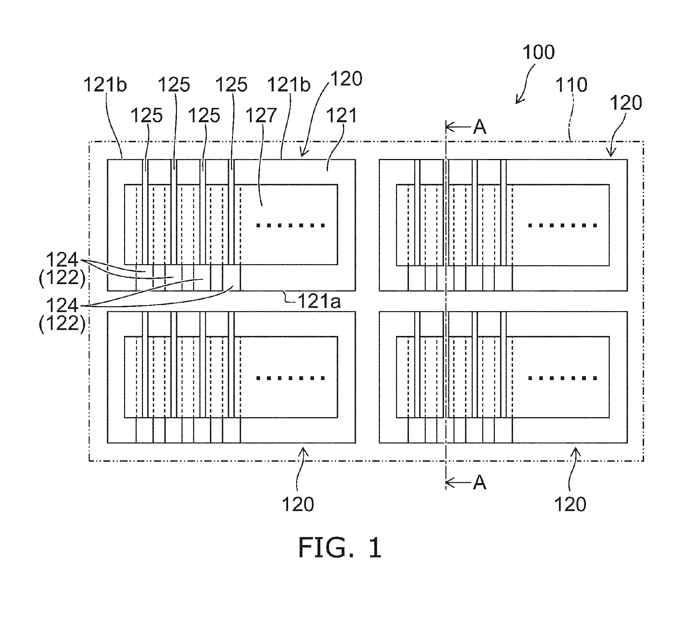

FIG. 1 is a schematic plan view illustrating a lighting device according to an exemplary embodiment.

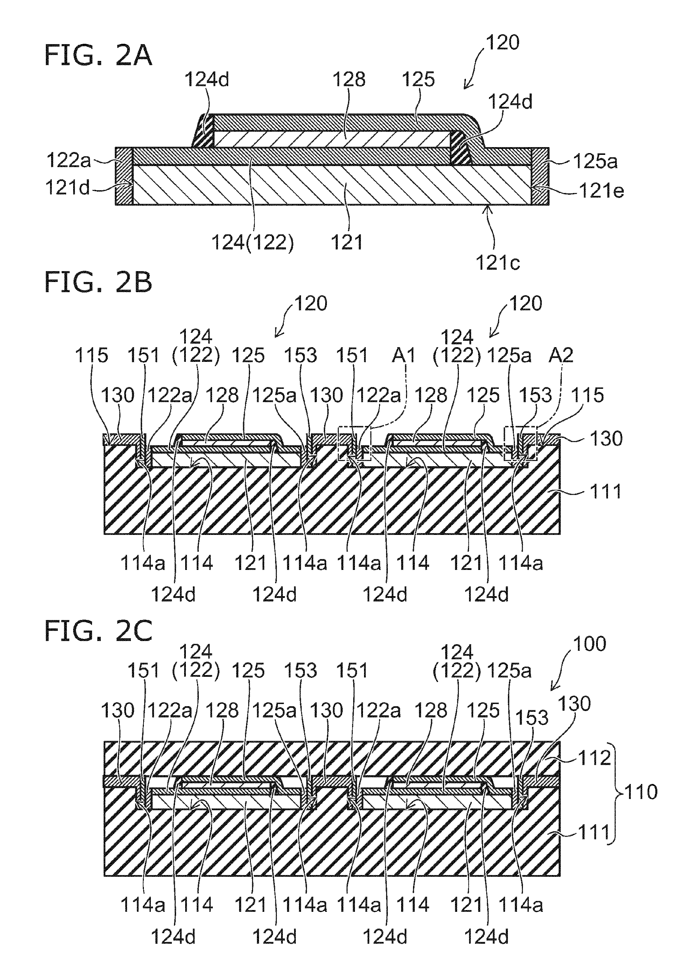

FIGS. 2A to 2C are schematic cross-sectional views illustrating a panel and the lighting device of the embodiment.

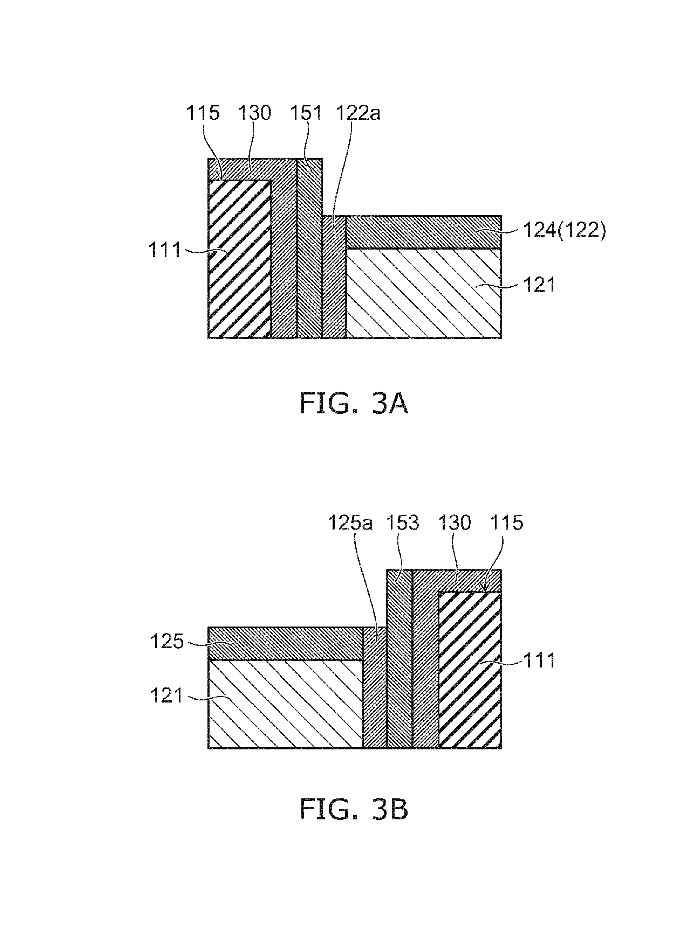

FIGS. 3A and 3B are schematic cross-sectional views illustrating the lighting device of the embodiment.

FIG. 2A is a schematic cross-sectional view illustrating the panel of the embodiment in cutting plane A-A illustrated in FIG. 1. FIGS. 2B and 2C are schematic cross-sectional views illustrating the lighting device of the embodiment in the cutting plane A-A illustrated in FIG. 1. FIG. 3A is an enlarged schematic view of a region A1 illustrated in FIG. 2B. FIG. 3B is an enlarged schematic view of a region A2 illustrated in FIG. 2B. In addition, the lighting device and the panel illustrated in FIGS. 1 to 3B are schematically illustrated, respectively.

A lighting device 100 according to an embodiment includes a frame 110, a panel 120, and a connection body 130. As illustrated in FIG. 2C, the frame 110 has a first frame body 111 and a second frame body 112. The frame 110 is formed of a material which is an insulating material capable of transmitting light (for example, acrylic or polycarbonate or the like capable of transmitting light).

In the specification of the application, the expression "a material which is capable of transmitting light" or "a material which transmits light" is not limited to materials having 100% of transmittance and means a material having transmittance being not zero with respect to at least light having a wavelength of visible light.

The lighting device 100 has a structure in which a plurality of panels 120 are sandwiched and sealed between the first frame body 111 and the second frame body 112. Specifically, as illustrated in FIGS. 2B and 2C, the first frame body 111 has a concave section 114. The depth of the concave section 114 is substantially the same as the thickness of the panel 120. The panel 120 is disposed in the concave section 114 provided in the first frame body 111. For example, the concave section 114 is formed in the first frame body 111 by cutting a flat plate.

In addition, in the lighting device 100 illustrated in FIG. 1, for example, the lighting device 100 has four panels 120. However, the number of the panel 120 is not limited to four and, for example, may be two. Hereinafter, a case that four panels 120 are provided is described as an example.

As illustrated in FIG. 2A, the panel 120 has a substrate 121, a first electrode 122, a second electrode 125, an organic layer 128, a first conductive body 122a and a second conductive body 125a. The substrate 121 is formed of a transparent material (for example, a glass or a resin material capable of transmitting light). At least a part of the organic layer 128 is provided between the first electrode 122 and the second electrode 125. Furthermore, in practice, the first electrode 122, the second electrode 125 and the organic layer 128 are sandwiched between the substrates 121 and a sealing substrate (not illustrated).

The panel 120 is a sheet-shaped panel emitting light by Organic Electro Luminescence (OEL) and includes Organic Light-Emitting Diode (OLED) which becomes transparent when off-lighting, that is, diode through which the opposite side of the panel can be seen. The panel 120 can emit light from a first main surface 121c (see FIG. 2A) of the substrate 121 to the outside when a voltage is supplied via the first electrode 122 and the second electrode 125. In other words, the organic layer 128 emits light in an emitting region 127 (see FIG. 1) and can emit light from the first main surface 121c of the substrate 121 to the outside when the voltage is applied between the first electrode 122 and the second electrode 125. In addition, it is possible that the light is hardly emitted from the second electrode 125.

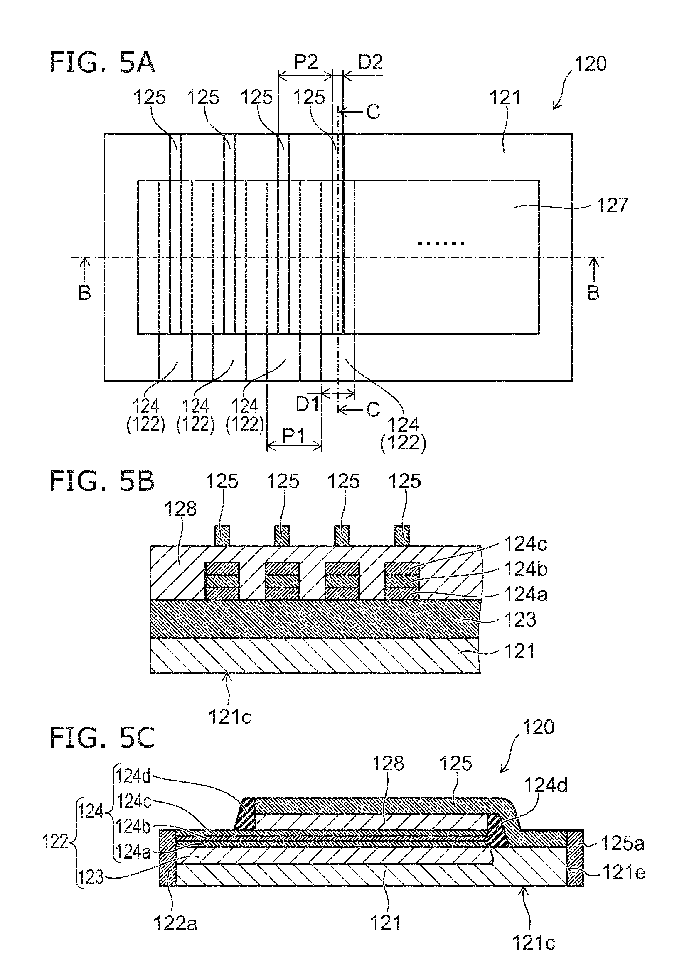

In the embodiment, the first electrode 122 is an anode electrode. The first electrode 122 has an electrode film 123 and an auxiliary wiring 124 (see FIGS. 5B and 5C). The electrode film 123 is formed of indium tin oxide (ITO) doped with tin as a transparent conductive film. The auxiliary wiring 124 has a structure in which a plurality of layers are laminated. The structure of the first electrode 122 will be described in detail later. As illustrated in FIG. 1, when viewing the lighting device 100 from the direction perpendicular to the first main surface 121c, the auxiliary wiring 124 passes through the emitting region 127 and extends to a first end portion 121a of the substrate 121. In other words, as illustrated in FIG. 1, when viewing the lighting device 100 from the direction perpendicular to the first main surface 121c, at least a part of the auxiliary wiring 124 is present in the emitting region 127 and one end of the auxiliary wiring 124 is disposed in the first end portion 121a of the substrate 121.

In the embodiment, the second electrode 125 is a cathode electrode. The second electrode 125 is, for example, formed by a metal material such as aluminum (Al). As illustrated in FIG. 1, when viewing the lighting device 100 from the direction perpendicular to the first main surface 121c, the second electrode 125 passes through the emitting region 127 and extends to a second end portion 121b of the substrate 121. In other words, as illustrated in FIG. 1, when viewing the lighting device 100 from the direction perpendicular to the first main surface 121c, at least a part of the second electrode 125 presents in the emitting region 127 and one end of the second electrode 125 is disposed in the second end portion 121b of the substrate 121.

In the embodiment, a plurality of auxiliary wirings 124 are provided. The plurality of auxiliary wirings 124 are connected to each other.

As illustrated in FIG. 2A, the first conductive body 122a is provided in a first side surface 121d of the substrate 121. The first conductive body 122a has conductivity and includes at least one of metal paste, carbon paste, conductive tape, and a solder material. The first conductive body 122a is electrically connected to the auxiliary wiring 124 (the first electrode 122).

In the embodiment, a plurality of second electrodes 125 are provided. The plurality of second electrodes 125 are connected to each other.

As illustrated in FIG. 2A, the second conductive body 125a is provided in a second side surface 121e of the substrate 121. The second conductive body 125a has conductivity and includes at least one of the metal paste, the carbon paste, the conductive tape, and the solder material. The second conductive body 125a is electrically connected to the second electrode 125.

An insulation layer 124d is provided between the first electrode 122 and the second electrode 125. The insulation layer 124d will be described later.

As illustrated in FIGS. 2B to 3B, the connection body 130 is provided on a side wall 114a of the concave section 114 of the first frame body 111 and an upper surface (a bonding surface between the first frame body 111 and the second frame body 112) 115 of the first frame body 111. The connection body 130 has conductivity and includes at least one of the metal paste, the carbon paste, the conductive tape, and the solder material. In addition, the connection body 130 is not limited to the paste shape or the tape shape and may include, for example, a wire material such as a generic lead wire.

In a state where the panel 120 is disposed in the concave section 114 of the first frame body 111, the connection body 130 is electrically connected to the first conductive body 122a via a third conductive body 151. The third conductive body 151 is provided between the first conductive body 122a and the connection body 130. In addition, in a state where the panel 120 is disposed in the concave section 114 of the first frame body 111, the connection body 130 is electrically connected to the second conductive body 125a via a fourth conductive body 153. The fourth conductive body 153 is provided between the second conductive body 125a and the connection body 130.

The third conductive body 151 and the fourth conductive body 153 include at least one of the metal paste, the carbon paste, the conductive tape and the solder material. The third conductive body 151 is provided with which a gap is filled between the first conductive body 122a and the connection body 130 after the panel 120 is disposed in the concave section 114 of the first frame body 111. The fourth conductive body 153 is provided with which a gap is filled between the second conductive body 125a and the connection body 130 after the panel 120 is disposed in the concave section 114 of the first frame body 111. In addition, the connection body 130 may be electrically connected to the first conductive body 122a and the second conductive body 125a, directly and respectively without passing through the third conductive body 151 and the fourth conductive body 153.

According to the embodiment, the panel 120 may be electrically connected to a power supply outside the frame 110 by the first conductive body 122a, the second conductive body 125a, the connection body 130, the third conductive body 151 and the fourth conductive body 153 in a state where the panel 120 is sandwiched and sealed between the first frame body 111 and the second frame body 112. In addition, the plurality of panels 120 may be electrically connected to each other by the first conductive body 122a, the second conductive body 125a, the connection body 130, the third conductive body 151 and the fourth conductive body 153 in a state where the panels 120 are sandwiched and sealed between the first frame body 111 and the second frame body 112. Thus, for example, it is possible to improve the electrical connection of the panels 120 while suppressing the thicknesses of the lighting device 100, the frame 110 and the panels 120 without necessity to separately provide a special wiring, for example, such as print wiring, that is, without damaging a fine appearance of the lighting device 100 including the transparent frame 110. The effect thereof is one of things which is meaningful in the lighting device 100 transparently unified as a whole by the panel 120 of the embodiment being an optically transmitting panel.

Furthermore, since the panel 120 the thickness of which is suppressed is sealed in the frame 110, handling of the lighting device 100 or electrical connection of a plurality of lighting device 100 becomes easier. Thus, it is possible to provide the transparent OLED lighting device having a great area.

Next, the panel 120 of the embodiment will be described with reference to the drawings.

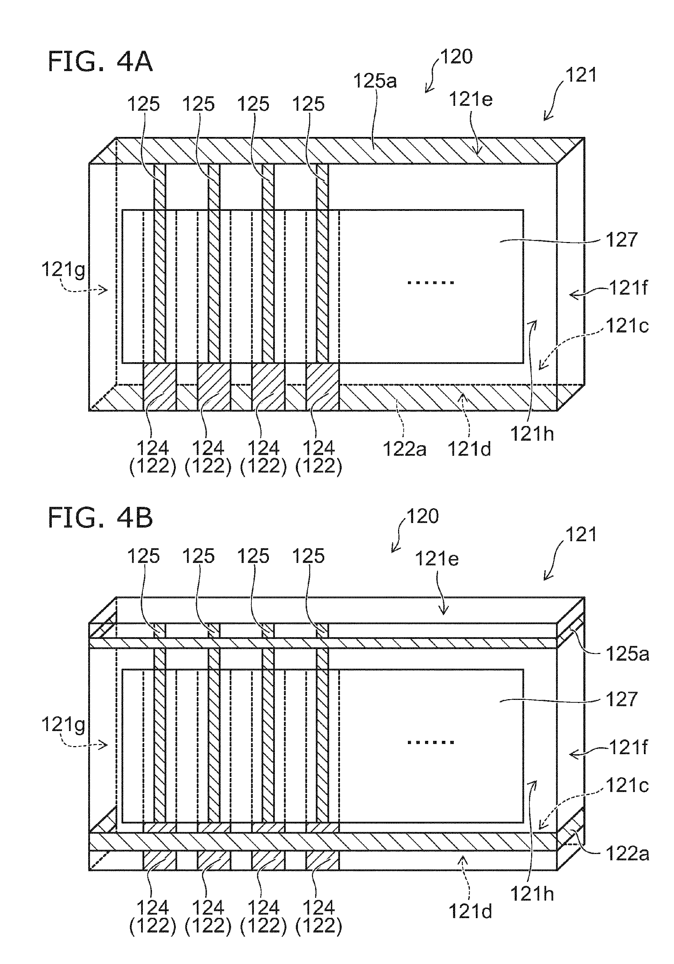

FIGS. 4A and 4B are schematic perspective views illustrating the panel of the embodiment.

FIGS. 5A to 5C are schematic views illustrating the panel of the embodiment.

FIG. 4A is a schematic perspective view illustrating an example of an installation mode of the first conductive body 122a and the second conductive body 125a in the panel 120 of the embodiment. FIG. 4B is a schematic perspective view illustrating another example of the installation mode of the first conductive body 122a and the second conductive body 125a in the panel 120 of the embodiment.

FIG. 5A is a schematic plan view illustrating the panel of the embodiment. FIG. 5B is a schematic cross-sectional view taken in cutting plane B-B illustrated in FIG. 5A. FIG. 5C is a schematic cross-sectional view taken in cutting plane C-C illustrated in FIG. 5A.

As illustrated in FIGS. 5B and 5C, in the panel 120 of the embodiment, the electrode film 123 of the first electrode 122 is provided on the substrate 121. The auxiliary wiring 124 is provided on the electrode film 123. The auxiliary wiring 124 is electrically connected to the electrode film 123. The auxiliary wiring 124 has a structure in which a plurality of layers are laminated. In the embodiment, the auxiliary wiring 124 has a first layer 124a, a second layer 124b, a third layer 124c, and the insulation layer 124d.

The first layer 124a is provided on the electrode film 123. The third layer 124c is provided on the first layer 124a. The second layer 124b is provided between the first layer 124a and the third layer 124c.

For example, the first layer 124a and the third layer 124c include molybdenum (Mo). For example, the second layer 124b includes aluminum (Al). The first layer 124a prevents the electrode film 123 from being discolored or the like caused by the second layer 124b to contact with the electrode film 123. Otherwise, the first layer 124a improves adhesion property between the second layer 124b and the electrode film 123. The third layer 124c suppresses electromigration caused by a current which excessively flows in the second layer 124b including aluminum.

As illustrated in FIG. 5A, the plurality of linear auxiliary wirings 124 are patterned by, for example, etching in a predetermined pitch P1 in the substantially entire upper surface of the first main surface 121c of the substrate 121. In other words, the plurality of auxiliary wirings 124 are present in stripe shapes which are provided at a position spaced from each other in the predetermined pitch P1. For example, the pitch P1 is approximately 0.5 mm to 1 mm. For example, a width (the length in the lateral direction in FIG. 5A) D1 of the auxiliary wiring 124 is approximately 50 µm to 100 µm. The auxiliary wiring 124 can spread the current which cannot be completely spread in a surface only with the surface of the electrode film 123 in the surface of the electrode film 123, and it is possible to improve conductivity of the first electrode 122. Therefore, the auxiliary wiring 124 can suppress uneven brightness in the surface of the panel 120.

As illustrated in FIGS. 5B and 5C, the insulation layer 124d is provided on a surface of a laminated body (for example, an upper surface or a side surface) in which the first layer 124a, the second layer 124b, and the third layer 124c are laminated. The insulation layer 124d insulates the electrical connection between the first layer 124a, the second layer 124b, the third layer 124c, and the second electrode 125. Accordingly, the insulation layer 124d suppresses that the electrode film 123 is governed by a work function of the auxiliary wiring 124. It is possible to maintain the work function of the electrode film 123 in approximately 5.0 electron volts (eV) indicating ITO.

In addition, the ITO film may be formed on the surfaces of the first layer 124a, the second layer 124b, and the third layer 124c by, for example, sputtering or the like instead of the insulation layer 124d. It is possible to optionally select whether the insulation layer 124d is formed or the ITO film is formed as flexibility of the process for making the panel 120.

As illustrated in FIG. 4A, the auxiliary wiring 124 is electrically connected to the first conductive body 122a. The first conductive body 122a is provided on the first side surface 121d of the substrate 121. This is as described with reference to FIGS. 1 to 2C. Furthermore, the first conductive body 122a is formed on substantially the entire surface of the first side surface 121d so that the plurality of auxiliary wirings 124 are electrically connected.

The organic layer 128 is provided on the first electrode 122. The second electrode 125 is provided on the organic layer 128. As illustrated in FIG. 5A, a plurality of second electrodes 125 are patterned by, for example, etching or the like in a predetermined pitch P2 on substantially the entire upper surface of the first main surface 121c of the substrate 121. In other words, the second electrodes 125 are provided at a position spaced from each other in the predetermined pitch P2. For example, the pitch P2 is approximately 0.5 mm to 1 mm and is the same width as the pitch P1 of the auxiliary wiring 124. For example, a width (the length in the lateral direction in FIG. 5A) D2 of the second electrode 125 is approximately 50 µm to 100 µm. In addition, in the panel 120 illustrated in FIGS. 4A to 5B, the width D2 of the second electrode 125 is narrower than the width D1 of the auxiliary wiring 124, but is not limited to the embodiment and may be the same as the width D1 of the auxiliary wiring 124.

In addition, the second electrode 125 is formed of indium tin oxide (ITO) doped with tin as a transparent conductive film similar to the first electrode 122.

As illustrated in FIG. 4A, the second electrode 125 is electrically connected to the second conductive body 125a. The second conductive body 125a is provided on the second side surface 121e of the substrate 121. This is as described with reference to FIGS. 1 to 2C. Furthermore, the second conductive body 125a is formed on the substantially entire surface of the second side surface 121e so that the plurality of second electrodes 125 are electrically connected.

A substrate or a film (not illustrated) is formed on the organic layer 128. In other words, the panel 120 of the embodiment has a structure in which the first electrode 122, the organic layer 128 and the second electrode 125 are sealed by being sandwiched between the substrate 121 and a substrate or a film (not illustrated). The substrate or the film (not illustrated) which is provided on the organic layer 128 is formed of a transparent material (for example, a glass or resin material capable of transmitting light) similar to the substrate 121. In addition, it is possible to form the organic layer 128 only in the region which is sandwiched between the first electrode 122 and the second electrode 125.

As described above, the auxiliary wiring 124 and the second electrode 125 are formed in the predetermined widths and are disposed in the predetermined pitches. The substrate or the film (not illustrated) provided on the substrate 121, the electrode film 123, and the organic layer 128 can transmit light. Thus, the light passes through the panel 120 from between the plurality of auxiliary wirings 124 and between the plurality of second electrodes 125. Therefore, it is possible to emit light by supplying the voltage to the panel 120 while ensuring transparency of the entire lighting device 100 when off-lighting.

In addition, as illustrated in FIG. 4B, the first conductive body 122a may be formed across a second main surface 121h, a third side surface 121f, and a fourth side surface 121g so as to electrically connect the plurality of auxiliary wirings 124. Similarly, the second conductive body 125a may be formed across the second main surface 121h, the third side surface 121f, and the fourth side surface 121g so as to electrically connect the plurality of second electrodes 125.

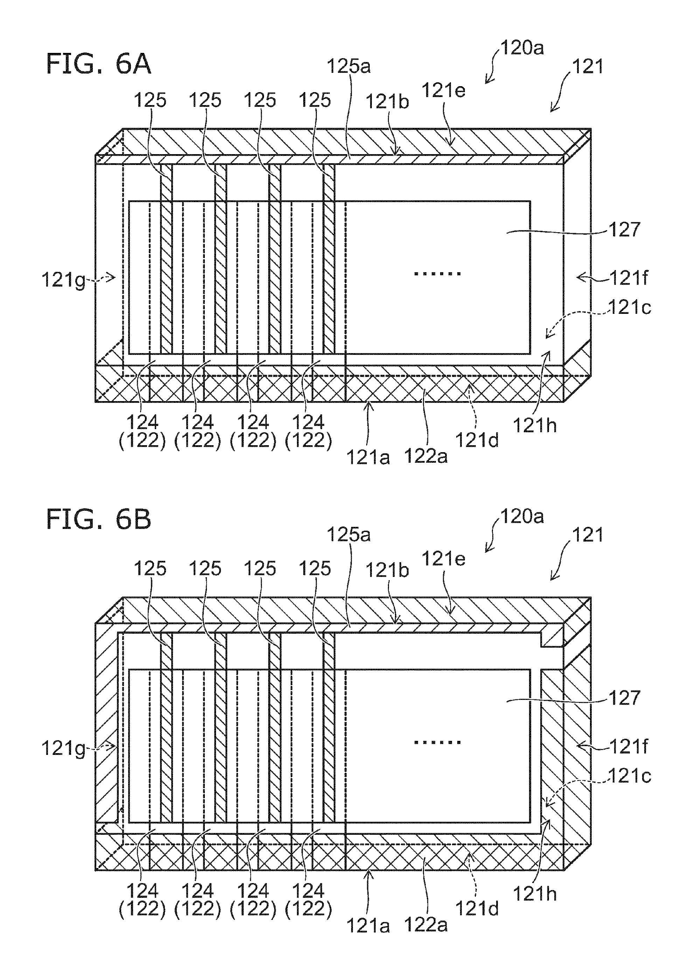

FIGS. 6A and 6B are schematic perspective views illustrating another panel of the embodiment.

FIG. 6A is a schematic perspective view illustrating an example of an installation mode of the first conductive body 122a and the second conductive body 125a in another panel of the embodiment. FIG. 6B is a schematic perspective view illustrating another example of the installation mode of the first conductive body 122a and the second conductive body 125a in another panel of the embodiment.

In a panel 120a of the embodiment, the first conductive body 122a is provided on the second main surface 121h, the first side surface 121d, the third side surface 121f, and the fourth side surface 121g in the first end portion 121a of the substrate 121 in addition to the first side surface 121d of the substrate 121. Accordingly, the plurality of auxiliary wirings 124 are electrically connected to each other via the first conductive body 122a. It is preferable that the first conductive body 122a be formed at the end portion of the second main surface 121h in order to ensure the electrical connection with the plurality of the auxiliary wiring 124.

The second conductive body 125a is provided on the second main surface 121h, the second side surface 121e, the third side surface 121f, and the fourth side surface 121g in the second end portion 121b of the substrate 121 in addition to the second side surface 121e of the substrate 121. Accordingly, the plurality of second electrodes 125 are electrically connected to each other via the second conductive body 125a. It is preferable that the second conductive body 125a be formed at the end portion of the second main surface 121h in order to ensure the electrical connection with the plurality of second electrodes 125.

The first conductive body 122a and the second conductive body 125a are formed in the locations described above by, for example, screen printing or the like. Other structures are the same as the structure of the panel 120 described above with respect to FIGS. 1 to 5C.

According to the panel 120a of the embodiment, it is not necessary to manually make connections between the plurality of auxiliary wirings 124 and between the plurality of second electrodes 125 after the auxiliary wiring 124 and the second electrode 125 are patterned. For example, it is possible to pattern the first conductive body 122a and the second conductive body 125a, respectively by the aforementioned screen printing using a screen plate after the auxiliary wiring 124 and the second electrode 125 are patterned. Therefore, it is possible to connect the plurality of auxiliary wirings 124 each other and to connect the first conductive body 122a and the auxiliary wiring 124 provided in the first side surface 121d, the third side surface 121f, and the fourth side surface 121g of the substrate 121. In addition, it is possible to connect the second conductive body 125a and the second electrode 125 provided on the second side surface 121e, the third side surface 121f and the fourth side surface 121g of the substrate 121 while the plurality of second electrodes 125 can be connected to each other.

Furthermore, since the first conductive body 122a is provided on the second main surface 121h, the first side surface 121d, the third side surface 121f and the fourth side surface 121g in the first end portion 121a of the substrate 121, it is possible to supply a substantially even voltage to the auxiliary wiring 124 (the first electrode 122). In addition, since the second conductive body 125a is provided on the second main surface 121h, the second side surface 121e, the third side surface 121f and the fourth side surface 121g in the second end portion 121b of the substrate 121, it is possible to supply a substantially even voltage to the second electrode 125.

In addition, as illustrated in FIG. 6B, the first conductive body 122a may be formed on the third side surface 121f while maintaining an insulation distance with respect to the second conductive body 125a. Similarly, the second conductive body 125a may be formed on the fourth side surface 121g while maintaining the insulation distance with respect to the first conductive body 122a.

Next, an example of an electrical connection between a plurality of panels and an example of an electrical connection between the panel and an external power supply will be described with reference to the drawings.

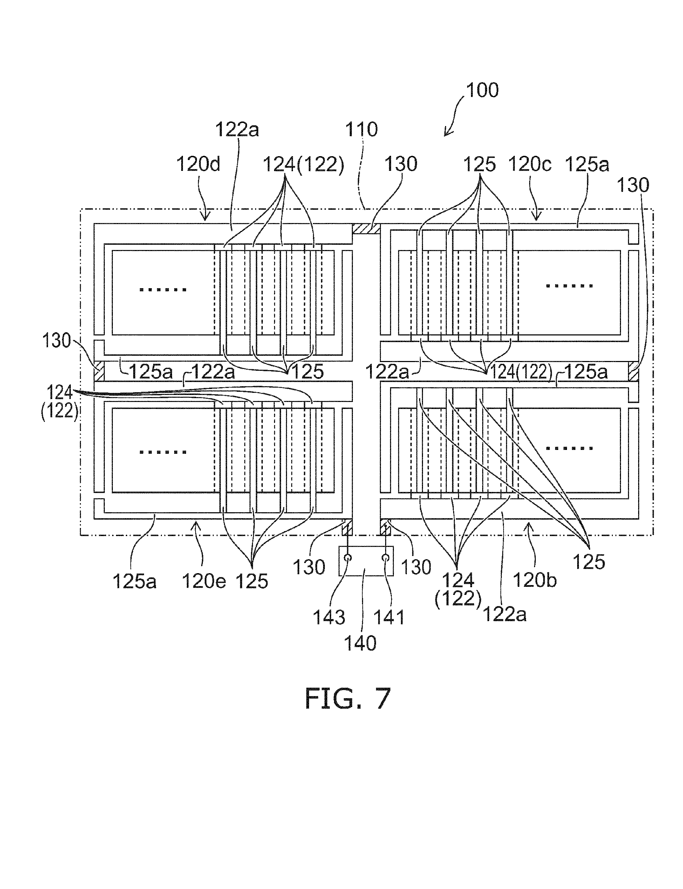

FIG. 7 is a schematic plan view illustrating an example of an electrical connection of the embodiment.

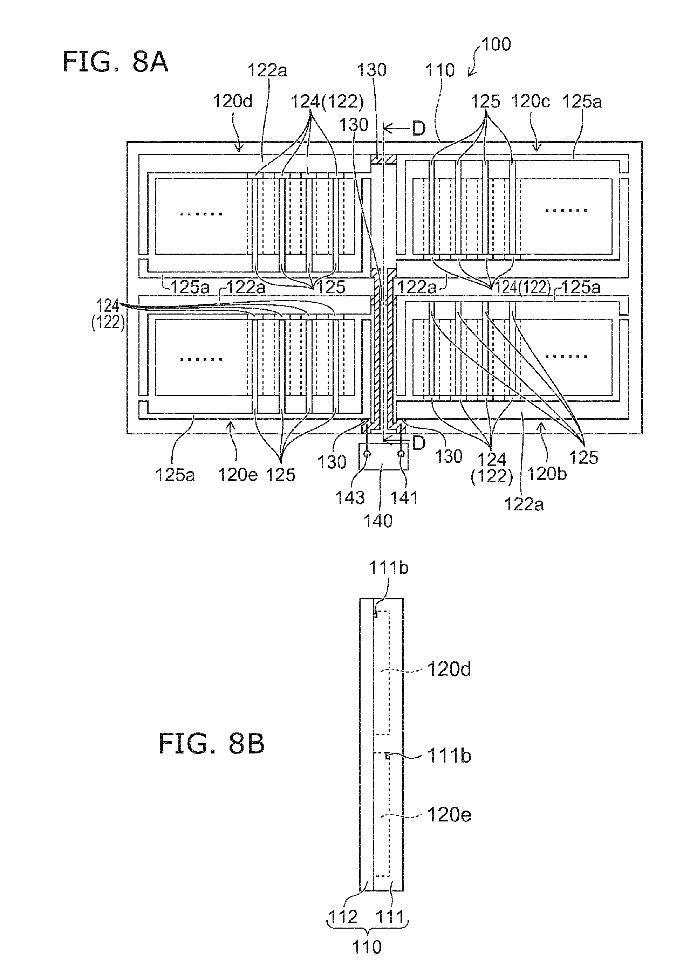

FIGS. 8A and 8B are schematic views illustrating another example of the electrical connection of the embodiment.

FIG. 8A is a schematic plan view illustrating the above mentioned another example of the electrical connection of the embodiment. FIG. 8B is a schematic cross-sectional view taken in cutting plane D-D illustrated in FIG. 8A.

In addition, in the electrical connection of the embodiment illustrated FIGS. 7 to 8B, a case that the panel 120a illustrated in FIG. 6B is used is described as an example.

The auxiliary wiring 124 (the first electrode 122) of a first panel 120b illustrated in FIG. 7 is connected to an anode 141 of an external power supply 140 via the first conductive body 122a and the connection body 130. In the embodiment, since a plurality of similar lighting devices 100 (for example, five sets) are disposed side by side, the external power supply 140 is disposed below the lighting device 100. In addition, as described with respect to FIGS. 2B, 2C and 3A, the third conductive body 151 may be provided between the first conductive body 122a and the connection body 130.

Subsequently, the second electrode 125 of the first panel 120b is connected to the auxiliary wiring 124 (the first electrode 122) of a second panel 120c via the second conductive body 125a, the connection body 130, and the first conductive body 122a. In addition, as described with respect to FIGS. 2B, 2C and 3B, the fourth conductive body 153 may be provided between the second conductive body 125a and the connection body 130.

Subsequently, the second electrode 125 of the second panel 120c is connected to the auxiliary wiring 124 (the first electrode 122) of a third panel 120d via the second conductive body 125a, the connection body 130, and the first conductive body 122a. Subsequently, the second electrode 125 of the third panel 120d is connected to the auxiliary wiring 124 (the first electrode 122) of a fourth panel 120e via the second conductive body 125a, the connection body 130 and the first conductive body 122a. Subsequently, the second electrode 125 of the fourth panel 120e is connected to a cathode 143 of the external power supply 140 via the second conductive body 125a and the connection body 130.

Accordingly, a serial circuit is formed between the first panel 120b, the second panel 120c, the third panel 120d, the fourth panel 120e, and the external power supply 140. When the external power supply 140 supplies the voltage to the lighting device 100, the first panel 120b, the second panel 120c, the third panel 120d, and the fourth panel 120e emit light from the first main surface 121c (see FIG. 2A) of the substrate 121 to the outside.

Furthermore, the aspect of the electrical connection illustrated in FIG. 7 is an example and the electrical connection of the embodiment is not limited to the aspect. For example, as illustrated in FIG. 8A, the first panel 120b and the fourth panel 120e connected to each other in series, and the second panel 120c and the third panel 120d connected to each other in series by the connection body 130 may be connected each other in parallel. In this case, as illustrated in FIG. 8B, the connection between the first panel 120b and the fourth panel 120e by the connection body 130 is performed via a through hole 111b formed in the first frame body 111. Therefore, the connection body 130 connecting the second panel 120c, the third panel 120d and the external power supply 140, and the connection body 130 connecting the first panel 120b and the fourth panel 120e may be three-dimensionally intercrossed.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A lighting device (100) comprising:
a plurality of panels (120) which emit light by organic electro luminescence;
a frame (110) formed of a light transmitting material which is an insulating material and sealing the plurality of panels (120); and
a connection body (130) having conductivity,
the panel (120) including
a substrate (121) formed by a light transmitting material;
a first electrode (122) which is provided on the substrate (121) and supplies a voltage to the panel (120);
a second electrode (125) which is provided on the substrate (121) and supplies a voltage to the panel (120);
a first conductive body (122a) which has conductivity, is connected to the first electrode (122) and is provided on a first side surface (121d) of substrate (121); and
a second conductive body (125a) which has conductivity, is connected to the second electrode (125), and is provided on a second side surface (121e) of substrate (121), and
the plurality of panels (120) being electrically connected to each other via the first conductive body (122a), the second conductive body (125a) and the connection body (130).

2. The device (100) according to claim 1,
wherein the frame (110) includes a concave section (114) in which the panel (120) is disposed, and
wherein the connection body (130) is provided on a side wall (114a) of the concave section (114).

3. The device (100) according to claim 2,
wherein the frame (110) includes a first frame body (111) in which the concave section (114) is formed and a second frame body (112) which is provided on the first frame body (111) and covers the panel (120), and
wherein the connection body (130) is further provided on a bonding surface (115) of the first frame body (111) and the second frame body (112).

4. The device (100) according to any one of claims 1 to 3,
wherein at least one of the first conductive body (122a), the second conductive body (125a) and the connection body (130) includes at least one of a metal paste, a carbon paste, a conductive tape, and a solder material.

5. The device (100) according to any one claims 1 to 4, further comprising:
a third conductive body (151) which is provided between the first conductive body (122a) and the connection body (130), and includes at least one of a metal paste, a carbon paste, a conductive tape, and a solder material; and
a fourth conductive body (153) which is provided between the second conductive body (125a) and the connection body (130), and includes at least one of a metal paste, a carbon paste, a conductive tape, and a solder material,
wherein the first conductive body (122a) is electrically connected to the connection body (130) via the third conductive body (151), and
wherein the second conductive body (125a) is electrically connected to the connection body (130) via the fourth conductive body (153).

6. The device (100) according to any one of claims 1 to 5,
wherein the first electrode (122) includes an auxiliary wiring (124) which passes through an emitting region (127) of the panel (120), extends to a first end portion (121a) of the substrate (121) and is electrically connected to the first conductive body (122a), when viewing the lighting device from the direction perpendicular to a first main surface (121c) of the substrate (121),
wherein a plurality of auxiliary wirings (124) and a plurality of second electrodes (125) are provided,
wherein the plurality of auxiliary wirings (124) are provided at a position spaced from each other in a predetermined pitch on the entire of the first main surface (121c), and
wherein the plurality of second electrodes (125) are provided at a position spaced from each other in a predetermined pitch on the entire of the first main surface (121c).

7. The device (100) according to claim 6,
wherein the plurality of auxiliary wirings (124) are electrically connected to each other via the first conductive body (122a), and
wherein the plurality of second electrodes (125) are electrically connected to each other via the second conductive body (125a).
